Europäisches Patentamt

European Patent Office

Office européen des brevets

(19)

(11) **EP 0 558 125 B1**

(12) **FASCICULE DE BREVET EUROPEEN**

(45) Date de publication et mention
de la délivrance du brevet:
**29.10.1997 Bulletin 1997/44**

(51) Int Cl.6: **G06F 15/80**

(21) Numéro de dépôt: **93200463.3**

(22) Date de dépôt: **18.02.1993**

(54) **Processeur neuronal à cellules synaptiques reparties**

Neuronaler Prozessor mit verteilten synaptischen Zellen

Neural processor with distributed synaptic cells

(84) Etats contractants désignés:
**DE FR GB IT**

(30) Priorité: **26.02.1992 FR 9202250**

(43) Date de publication de la demande:
**01.09.1993 Bulletin 1993/35**

(73) Titulaires:
• **LABORATOIRES D'ELECTRONIQUE PHILIPS
S.A.S.**
**94450 Limeil-Brévannes (FR)**
Etats contractants désignés:
**FR**
• **Philips Electronics N.V.**
**5621 BA Eindhoven (NL)**
Etats contractants désignés:
**DE GB IT**

(72) Inventeur: **Gobert, Jean**
**F-75008 Paris (FR)**

(74) Mandataire: **Landousy, Christian et al**
**Société Civile S.P.I.D.**
**156, Boulevard Haussmann**
**75008 Paris (FR)**

(56) Documents cités:
• **INNC90- INTERNATIONAL NEURAL NETWORK
CONFERENCE vol. 2, 9 Juillet 1990, PARIS,
FRANCE pages 661 - 664 HUCH 'Bachus : a vlsi
architecture for a large binary associative
memory'**
• **IEEE TRANSACTIONS ON CIRCUITS AND
SYSTEMS vol. 36, no. 5, Mai 1989, NEW YORK
US pages 732 - 738 VAN DEN BOUT 'A digital
architecture employing stochasticism for the
simulation of hopfield neural nets'**
• **IJCNN INTERNATIONAL JOINT CONFERENCE
ON NEURAL NETWORKS vol. 2, 17 Juin 1990,
SAN DIEGO,USA pages 527 - 535 YASUNAGA
'Design, fabricatio and evaluation of 5-inch
wafer scale neural network lsi composed of 576
digital neurons'**
• **IEEE CIRCUITS AND DEVICES MAGAZINE vol. 6,
no. 4, Juillet 1990, NEW YORK US pages 13 - 17
MASAKI 'A 576-neuron wafer-scale CMOS circuit
solves the 16-city traveling salesman problem in
less than a tenth of a second'**
• **IEEE INTERNATIONAL SOLID STATE CIRCUITS
CONFERENCE vol. 34, Février 1991, NEW YORK
US pages 180 - 181 GRIFFIN 'An 11-million
transistor neural network execution engine'**

## Description

L'invention concerne un processeur neuronal comprenant :

- des moyens d'entrée de signaux numériques,
- une pluralité de moyens de stockage de coefficients synaptiques,
- une pluralité de moyens de stockage d'états de neurones,
- une pluralité de moyens de calcul de potentiels neuronaux.

Il peut s'agir de machines simples, par exemple un accélérateur arithmétique permettant d'améliorer les performances de mises en oeuvre logicielles d'algorithmes neuronaux ou de machines complexes, par exemple des réseaux de neurones complets réalisés sous forme de circuits très spécialisés en technologie numérique ou analogique.

Que les machines soient simples ou complexes, elles comportent un ensemble de ressources que l'on peut grouper selon trois fonctions :

- mémorisation : cela concerne d'une part la mémorisation de coefficients synaptiques caractérisant des synapses reliant entre eux deux neurones et d'autre part la mémorisation des états de neurones,
- interconnexion : cela concerne la mise en relation d'un neurone avec un autre neurone pour la transmission et/ou l'échange de différents signaux de contrôle et des signaux de données,
- traitement : cela concerne le calcul de différentes données, en particulier le calcul des potentiels neuronaux des neurones et le calcul des mises à jour des coefficients synaptiques lors des étapes d'apprentissage.

Selon l'art antérieur le plus répandu, un processeur neuronal dispose d'une unité de mémorisation qui stocke globalement la totalité des coefficients synaptiques, chaque coefficient synaptique étant accédé par une adresse dans l'unité de mémorisation. La fonction interconnexion est alors obtenue implicitement par câblage d'après l'ordre de rangement (donc les adresses) des coefficients synaptiques dans l'unité de mémorisation: tous les coefficients synaptiques d'un même neurone sont rangés à des adresses connues (qui sont généralement successives) de sorte qu'il suffit d'incrémenter/décrémenter une adresse pour disposer desdits coefficients synaptiques.

Les ressources allouées aux synapses ne représentent dans ce cas que la partie mémorisation, les autres fonctions doivent être effectuées dans l'unité de traitement. Pour offrir un avantage par rapport aux réalisations purement logicielles, il faut mettre en oeuvre un certain degré de parallélisme, et pour cela l'unité de traitement se compose en fait de n sous-unités de traitement, chacune traitant 1/n des opérations du réseau. Afin de limiter le nombre d'interconnexions physiques, une sous-unité est connectée de façon rigide à 1/n de la mémoire synaptique.

Pour les mêmes raisons de limitation des interconnexions, une sous-unité ne peut pas s'occuper du traitement correspondant à des neurones quelconques, indépendamment des synapses qui lui sont affectées. Le découpage du réseau en sousunités induit donc des relations entre les synapses contenues dans une partition mémoire et les neurones concernés par ces synapses. Par exemple, le nombre de synapses arrivant à un neurone déterminé ne peut être supérieur à la taille d'un bloc mémoire affecté à une sous-unité.

Cela débouche sur un mauvais rendement d'utilisation du matériel. Afin de simplifier le contrôle, on majore le nombre de cycles de calcul des sous-unités au nombre maximum nécessaire pour la configuration la plus compliquée admissible par le dispositif. De même, certains mots des mémoires ne seront pas utilisés parce qu'ils appartiennent à des blocs correspondant à des neurones ayant peu de synapses.

Des tentatives ont été faites pour rendre plus optimales les durées de traitement et pour mieux proportionner le hardware aux situations diverses rencontrées.

On connaît ainsi le document intitulé :

"A wafer scale integration neural network utilizing completely digital circuits" par M. YASUNAGA et al, IEEE INNS International Joint Conf. on Neural Networks II - 213 (1989).

Pour ne tenir compte que de la partie concernant l'invention, ce papier décrit une réduction du nombre d'interconnexions arrivant sur un même neurone. Pour cela l'architecture est découpée en neurones dans laquelle un neurone est un bloc recevant, à un instant donné, une seule synapse. Ce bloc reçoit successivement en temps partagé, à partir d'un bus commun, des données relatives à toutes les synapses arrivant sur ce neurone.

On dispose ainsi d'autant d'unités de traitement et d'unités de mémorisation qu'il y a de neurones. Pour un même neurone, une mémoire de petite taille stocke tous les coefficients synaptiques relatifs à ce neurone. Ils sont adressés séquentiellement comme dans le cas d'une architecture non répartie. Ce mode de fonctionnement permet de réduire le nombre des interconnexions arrivant sur un neurone.

Mais une telle architecture reste figée, en particulier il n'est pas possible de modifier unité par unité le nombre de synapses connectées à un neurone. Ceci n'apporte donc pas de souplesse pour attribuer au processeur neuronal une nouvelle configuration de répartition de synapses.

Le découpage de la mémoire en modules accessibles pour effectuer les traitements concernant les synapses impose donc des contraintes sur la topologie du réseau. Ceci entraîne qu'un réseau de topologie arbitraire, défini par un ensemble de neurones et par leurs interconnexions, ne peut pas toujours être plaqué sur le dispositif matériel, même si le nombre total de neurones et de synapses est inférieur à ce que saurait gérer théoriquement le système.

Le but de l'invention est donc de faire que la configuration du processeur neuronal soit libre de toute contrainte vis-à-vis de la topologie du processeur et offre des moyens pour modifier dynamiquement cette configuration. Pour cela, on désire s'affranchir de la contrainte liée à un nombre fixe de synapses par neurone afin d'éviter soit une non utilisation de ressources qui deviennent inutiles lorsqu'un neurone a peu de synapses, soit d'imposer un nombre maximal de synapses par neurone qui serait trop restreint.

Ce but est atteint selon l'invention avec un processeur neuronal pour lequel lesdites pluralités de moyens sont réparties unitairement dans une pluralité de cellules synaptiques, une cellule synaptique étant allouée à une seule synapse, les cellules synaptiques :

- recevant en parallèle :

  . un bus d'adresses ADR,
  . un bus de type d'opérations TYPE,

- et communiquant en chaîne de l'une à l'autre par :

  . au moins un chemin chaîné DATA pour propager des données,
  . et un chemin chaîné BUSY pour propager un signal d'occupation,

chaque cellule synaptique comprenant :

- des moyens d'allocation ALLOC pour attribuer, à ladite cellule synaptique, un état libre/occupé propagé par le chemin chaîné BUSY,
- des moyens d'adressage ADDR :

  . pour stocker une adresse de ladite cellule synaptique, adresse formée d'un identificateur de neurone source et d'un identificateur de neurone destination,
  . et pour comparer ladite adresse et une adresse courante fournie par le bus d'adresses ADR pour déterminer si ladite cellule synaptique doit devenir opérante,

- des moyens de traitement PROCES pour effectuer des opérations définies par le bus TYPE et effectuées sur les données du chemin chaîné DATA.

Ainsi avantageusement l'invention alloue à chaque cellule synaptique :

- une fonction de mémorisation (de données),
- une fonction d'interconnexion,
- une fonction de traitement.

En ce qui concerne la fonction de mémorisation de données, la cellule synaptique stocke un seul coefficient synaptique et les deux états de neurones des neurones connectés en amont (source) et en aval (destination) par la synapse matérialisée par la cellule synaptique.

En ce qui concerne la fonction d'interconnexion, la cellule synaptique mémorise un identificateur du neurone source et un identificateur du neurone destination. Il n'y a aucune relation entre la position topologique de la cellule synaptique et ses identificateurs de neurones source/destination.

En ce qui concerne la fonction de traitement, une cellule synaptique renferme un moyen unitaire de calcul qui calcule la contribution élémentaire fournie par la cellule synaptique au potentiel neuronal du neurone destination. Ce moyen unitaire de calcul participe également à d'autres étapes de calcul en particulier à la mise à jour des coefficients synaptiques au cours des étapes d'apprentissage.

Toutes les cellules synaptiques communiquent entre elles par deux types de communication :

- une communication en parallèle : toutes les cellules synaptiques reçoivent en parallèle :

  . le bus ADR qui adresse associativement les cellules synaptiques,

EP 0 558 125 B1

. le bus TYPE qui indique aux cellules synaptiques les types d'opérations à faire effectuer par les unités de traitement,

- une communication chaînée : chaque cellule synaptique communique à une cellule synaptique suivante :

. un signal d'occupation qui change d'état dès qu'une cellule synaptique a été sélectionnée (chemin chaîné BUSY),
. le résultat de sa contribution (chemin chaîné de données DATA), ou opère en transparence.

Entre les cellules synaptiques, les communications sur les chemins chaînés se font de façon simultanée et unidirectionnelle dans toute la pluralité de cellules synaptiques. Une "instruction" entre en entrée du processeur neuronal et transite de proche en proche jusqu'à la sortie de la pluralité de cellules synaptiques. Chaque cellule synaptique reçoit une suite d'opérations entrantes, et pour chacune d'entre elles :

- lorsqu'elle n'est pas concernée, elle reste transparente pour cette opération et transfère les données inchangées à la cellule synaptique suivante,
- lorsqu'elle est concernée, elle effectue ladite opération en tenant compte des données entrantes et, par exemple, calcule sa propre contribution qu'elle cumule avec les résultats des cellules qui la précèdent ayant des neurones en commun. Pour chaque opération, un résultat est déterminé puis est transmis à la cellule synaptique suivante.

Ce mode de fonctionnement nécessite de traverser toutes les synapses avant qu'une opération soit considérée comme étant terminée. Cela peut aboutir à un temps de latence qui peut, dans certains cas, être long. Pour réduire ce temps de latence, il est possible de subdiviser la pluralité de cellules synaptiques en plusieurs groupes ordonnés de cellules synaptiques qui opèrent en parallèle, un groupe ordonné étant muni d'un propre chemin chaîné DATA. Chaque cellule synaptique ayant dans son groupe un numéro d'ordre, le chemin chaîné BUSY passe, en progression croissante ou décroissante, dans des cellules synaptiques ayant, dans chaque groupe, un même numéro d'ordre, puis dans des cellules synaptiques, ayant dans chaque groupe, un même numéro d'ordre suivant.

Le temps de cycle peut être réduit en groupant des cellules synaptiques par section, à l'aide de barrières de pipeline ce qui réduit le temps séparant le traitement de deux instructions consécutives. Les groupes ordonnés sont alors subdivisés à l'identique en sections qui sont séparées les unes des autres par des barrières de pipeline, les sections, adjacentes d'un même côté à une barrière de pipeline, ayant pour tous les groupes ordonnés un nombre identique de cellules synaptiques.

Ces différents aspects de l'invention et d'autres encore seront apparents et élucidés à partir des modes de réalisation décrits ci-après.

L'invention sera mieux comprise à l'aide des figures suivantes, données à titre d'exemples non limitatifs, qui représentent :

Figure 1 : un schéma général des éléments essentiels d'un processeur neuronal connu.
Figure 2 : un schéma général d'une cellule synaptique selon l'invention.
Figure 3 : un schéma général d'un processeur neuronal selon l'invention, subdivisé en une pluralité de cellules synaptiques.
Figure 4 : un schéma d'un circuit d'allocation servant à écrire dans un module d'allocation.
Figure 5 : un schéma d'un module d'allocation.
Figure 6 : un schéma d'un module d'adressage.
Figure 7 : un schéma d'un module de traitement.
Figure 8 : un schéma général d'un processeur neuronal avec une pluralité de cellules synaptiques subdivisée en plusieurs groupes ordonnés de cellules synaptiques.
Figure 9 : un schéma analogue à celui de la figure 8 avec des barrières de pipeline.

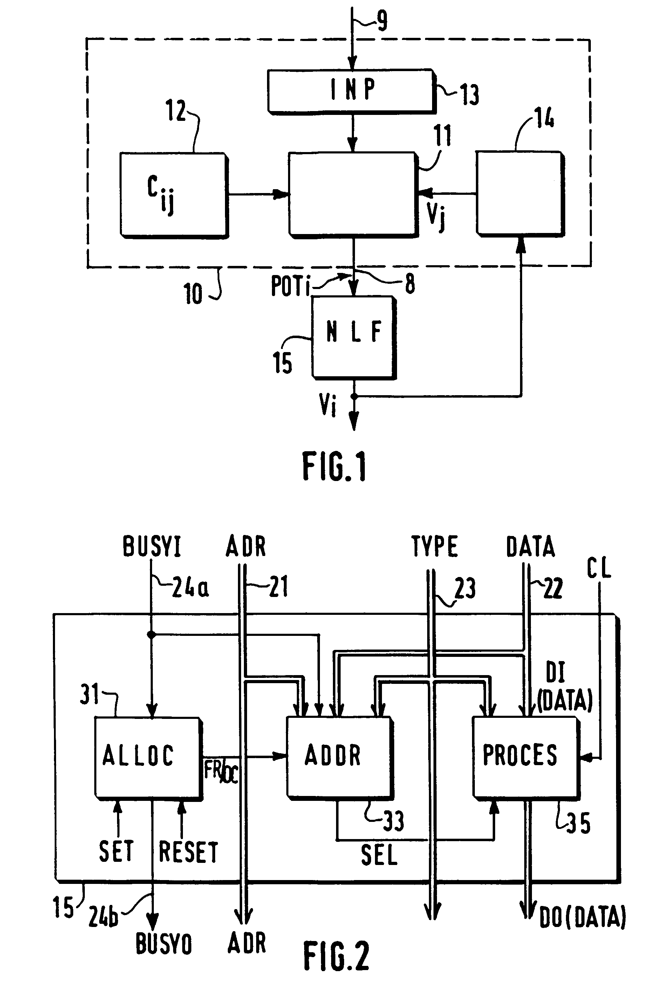

La figure 1 représente un schéma simplifié d'une architecture connue de processeur neuronal 10. Des moyens d'entrée INP 13 (par exemple des registres d'entrée ou des bornes d'entrée), fournissent des données 9 à une unité de traitement 11 qui reçoit également des coefficients synaptiques $C_{ij}$ stockés dans des moyens de stockage 12. Un coefficient synaptique $C_{ij}$ caractérise le poids de la synapse qui connecte un neurone source j à un neurone destination i. L'unité de traitement 11 reçoit également des états de neurones stockés dans des moyens de stockage 14.

Lorsqu'un neurone opère en tant que neurone source, son état est référencé par $V_j$ et lorsqu'il opère en tant que neurone destination, son état est référencé par $V_i$. L'unité de traitement 11 opère pour chaque neurone destination des calculs :

4

$$POT_i = \sum_j C_{ij} \cdot V_j$$

L'unité de traitement 11 effectue la sommation sur tous les neurones source d'indice j et fournit en sortie (connexion 8) le potentiel neuronal $POT_i$ du neurone destination i. Ce potentiel neuronal $POT_i$ est soumis à l'action d'une fonction non-linéaire NLF 15 qui fournit le nouvel état de neurone $V_i$ du neurone destination i. Ce nouvel état $V_i$ est utilisé pour mettre à jour les moyens de stockage 14 et le processus continue pour d'autres neurones. Les moyens d'application 15 de la fonction non-linéaire NLF sont représentés extérieurs au processeur neuronal 10. Cette figure 1 est seulement illustrative de l'architecture car ces moyens d'application 15 peuvent également être placés à l'intérieur du processeur neuronal 10. Par souci de simplification, d'autres organes ont été omis : des moyens de contrôle (par exemple un calculateur hote), des moyens d'apprentissage,...

L'architecture de la figure 1 est représentée sous forme de blocs fonctionnels, chaque bloc étant affecté à une fonction unique : stockage des coefficients synaptiques, stockage des états neuronaux, traitement... Pour réduire le nombre des interconnexions, il est possible de concevoir une architecture éclatée en blocs modulaires comme cela est décrit dans l'article de M. YASUNAGA et al. déjà cité. Dans ce cas, un bloc modulaire concerne un seul neurone, ledit bloc modulaire étant "approvisionné" par toutes les données de toutes les synapses concernant ce bloc modulaire.

L'invention va bien au-delà de cette conception en définissant une architecture éclatée jusqu'au niveau des synapses elles-mêmes et en définissant les communications des synapses entre elles quelle que soit leur affectation à un quelconque des neurones et leur rangement dans les chaînes de synapses.

### Mode de réalisation principal.

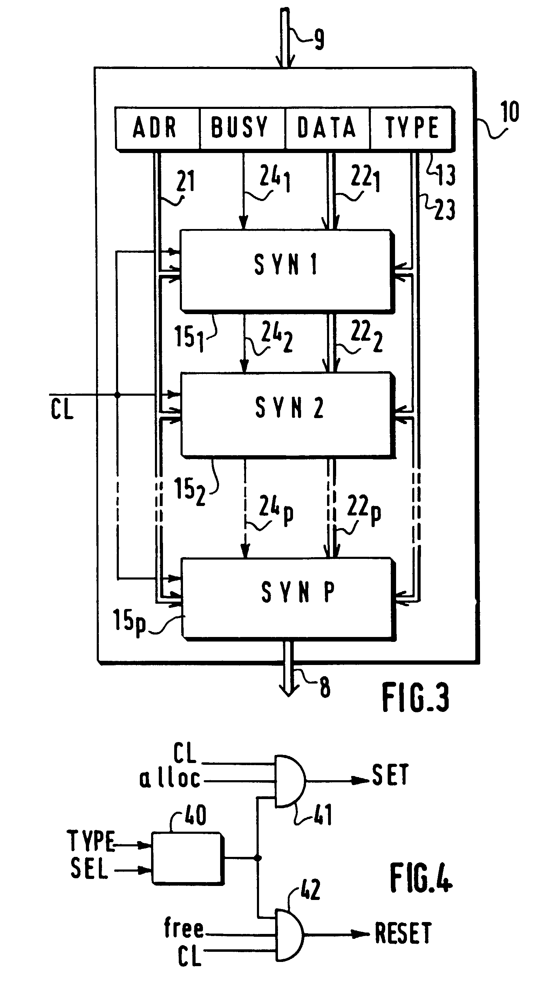

Un mode principal de réalisation du processeur neuronal (10) selon l'invention est représenté sur le schéma général de la figure 3. Le processeur neuronal 10 comprend des moyens d'entrée 13 (par exemple des registres d'entrée ou des bornes d'entrée) qui reçoivent de l'extérieur plusieurs champs d'informations :

ADR : un champ d'adresses
BUSY : un signal d'occupation
DATA : un champ de données
TYPE : un champ de type d'opérations à effectuer sur les données.

Une combinaison de tous ces champs d'informations constitue une instruction. L'utilisation du circuit se fait en présentant successivement des suites d'instructions. Les principales instructions sont détaillées sur le tableau I.

Ce tableau indique la composition du champ DATA pour certaines instructions. Par exemple, lorsque le type d'opérations indique une étape de gestion de synapses, le champ DATA va contenir un bit alloc qui, lorsqu'il est à l'état logique 1, détermine l'instruction "allocation de synapse". Dans ce cas, le champ DATA contient également un champ de données appelées "data" sur lequel portent les opérations à effectuer. Dans le cas où le champ TYPE indique une opération d'accumulation, la totalité du champ DATA est affectée aux données "data". Les autres instructions du tableau I doivent être lues de manière analogue.

TABLEAU I

| TYPE | DATA | | INSTRUCTIONS |
|---|---|---|---|
| Gestion synapse | 1 bit alloc ; si alloc = 1 | data | Allocation de synapse |
| | 1 bit free ; si free = 1 | - | Libération de synapse |
| Lecture / écriture | 1 bit read ; si read = 1 | - | Lecture du coefficient synaptique |
| | 1 ou plusieurs bits write | data | Ecriture registres (SN, DN, CV ou M) |

TABLEAU I   (suite)

| TYPE | DATA | | INSTRUCTIONS |
|---|---|---|---|
| Accumulation | data | | Accumulation |
| Opération | Multi = 1 | | Multiplication |
| | 1 à 7 autres bits utilisés pour préciser l'opération | - | |
| | Multi = 0 | | Autres opérations internes |
| | 7 bits utilisés pour préciser l'opération | - | |

L'architecture du processeur neuronal est constituée de cellules synaptiques SYN 1, SYN 2, ...SYN P. Toutes les cellules synaptiques ont une structure identique. Elles communiquent entre elles globalement de deux manières différentes :

- elles reçoivent toutes en parallèle :

  . le champ d'adresses ADR distribué en parallèle par le bus 21,
  . et le champ de type d'opérations TYPE distribué en parallèle par le bus 23.

- elles communiquent en chaîne :

  . par un chemin chaîné DATA $22_1$, $22_2$,... $22_P$
  . et par un chemin chaîné BUSY $24_1$, $24_2$,... $24_P$.

La dernière cellule synaptique SYN P de la chaîne délivre sur le bus 8 des résultats d'opérations, par exemple des calculs de potentiels neuronaux. En outre, un signal d'horloge CL est distribué à l'ensemble des synapses.

Toutes les cellules synaptiques ont la même architecture. Ainsi une cellule synaptique 15 est représentée sur la figure 2. Elle comprend :

- des moyens d'allocation 31,
- des moyens d'adressage ADDR 33,
- des moyens de traitement PROCES 35.

Les moyens d'allocation 31 reçoivent en entrée un signal BUSY I en provenance d'une cellule synaptique précédente et délivrent en sortie d'une part un signal d'occupation BUSY O à une cellule synaptique suivante et d'autre part un signal FR/OC aux moyens d'adressage ADDR indiquant un état libre FR ou occupé OC de la cellule synaptique.

En phase d'exploitation de cellules synaptiques allouées, lorsqu'une adresse courante ADR est émise sur le bus d'adresses 21, les moyens d'adressage 33 activent un signal SEL lorsque l'adresse allouée à la cellule synaptique et l'adresse courante sont identiques. Le signal SEL déclenche alors les moyens de traitement PROCES 35 pour qu'ils opèrent des opérations dont le type est déterminé par le champ TYPE. Ces opérations sont effectuées sur des données entrantes DI c'est-à-dire les données "data" contenues dans le champ de données DATA. Après leur traitement, ces données entrantes DI donnent naissance à des données sortantes DO.

Lorsque l'adresse allouée à la cellule synaptique et l'adresse courante sont différentes, la cellule synaptique n'est pas concernée et elle se limite à transférer à la cellule synaptique suivante un champ de données sortantes DO identique au champ de données entrantes DI.

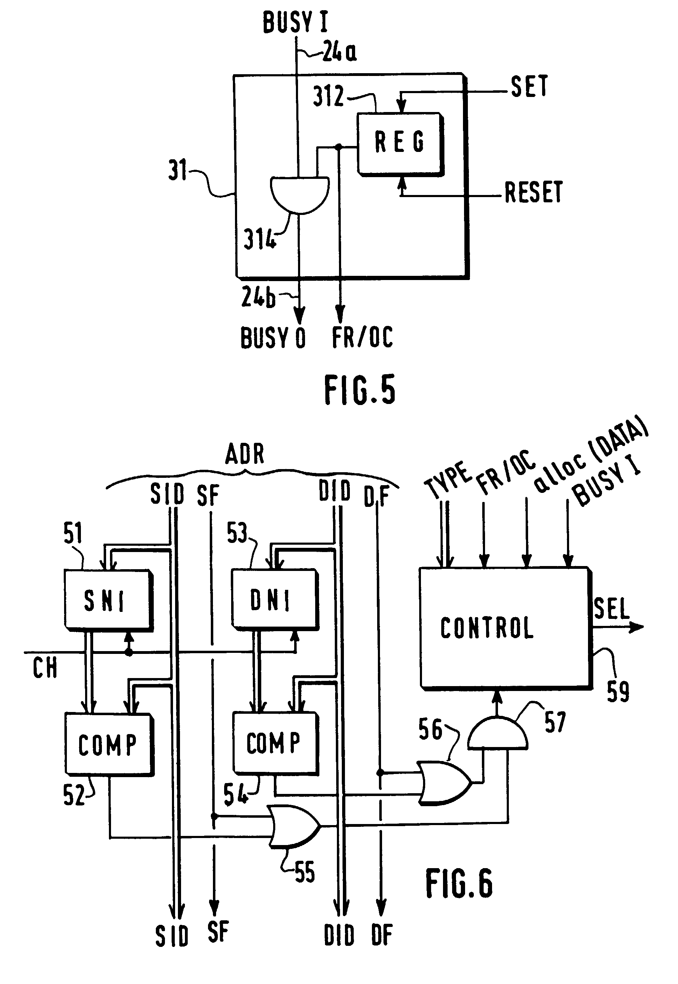

Les différents moyens de la cellule synaptique 15 sont représentés sur les figures 5, 6 et 7.

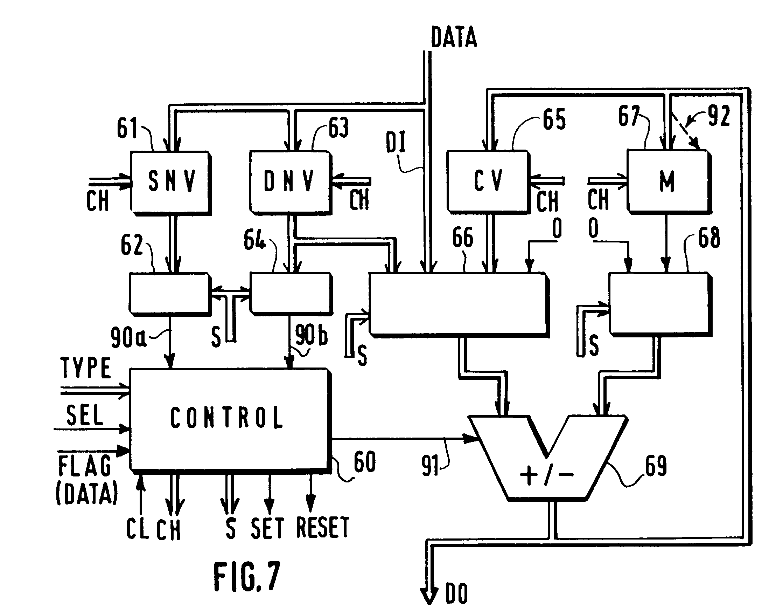

Les moyens d'allocation 31 sont représentés sur la figure 5. Un registre REG 312 stocke un état occupé (REG = 1) ou un état libre (REG = 0) de la cellule synaptique. Ces états libre/occupé peuvent être modifiés par des commandes SET/RESET provenant des moyens de traitement 35 (figures 2 et 7).

Une porte ET 314 effectue une fonction ET logique entre la sortie du registre 312 et le signal BUSY I entrant provenant de la cellule synaptique précédente. Le signal sortant BUSY O est à 1 lorsque le signal entrant BUSY I est à 1 (toutes les cellules précédentes occupées) et lorsque REG est à 1 (la cellule synaptique 15 est occupée). Lorsque BUSY I est à 1 et REG à 0, la cellule synaptique 15 est libre et BUSY O est à 0.

Dans la chaîne, seule la première cellule synaptique libre possède un signal BUSY I à 1 et un signal BUSY O à 0. Ceci permet de sélectionner la première cellule synaptique libre pour effectuer des opérations d'allocation.

En phase d'exploitation, le signal FR/OC émis par les moyens d'allocation 31 commande les moyens d'adressage 33.

La figure 6 représente les moyens d'adressage ADDR 33 pour une cellule synaptique se rapportant à une synapse quelconque caractérisant la liaison pondérée entre un neurone source et un neurone destination. Le bus d'adresses ADR contient plusieurs champs de données :

- un champ SID qui est un identificateur du neurone source de la ou des synapses concernées par l'instruction,
- un champ DID qui est un identificateur du neurone destination de la ou des synapses concernées par l'instruction,
- deux bits SF et DF précisant la façon dont se fait l'adressage. Ces deux bits SF et DF donnent naissance à un signal de filtrage SF et à un signal de filtrage DF pouvant être activés indépendamment pour adresser respectivement soit toutes les cellules synaptiques connectées à un même neurone destination, soit toutes les cellules synaptiques connectées à un même neurone source et pouvant être activées simultanément pour adresser toutes les cellules synaptiques.

Les identificateurs SID et DID sont chargés respectivement dans des registres 51 et 53 au cours des étapes d'allocation, sous contrôle de la commande de chargement CH (champ à plusieurs bits) qui est délivrée par les moyens de traitement 35. A l'issue de la phase d'allocation d'une cellule synaptique, les identificateurs SID et DID présents sur les bus deviennent respectivement les identificateurs SNI et DNI alloués, chargés respectivement dans les registres 51 et 53. En phase d'exploitation, des adresses courantes sont placées sur le bus ADR. Des comparateurs 52 et 54 comparent alors respectivement les identificateurs SNI et DNI alloués avec des identificateurs SID et DID contenus dans l'adresse courante.

Pour toutes les instructions, sauf l'instruction d'allocation, une synapse allouée peut être sélectionnée suivant quatre modalités, spécifiées par les bits SF et DF :

mode 1 :     sélection inconditionnelle (toutes les synapses sont concernées),
mode 2 :     sélection si SID = SNI (par le neurone source),
mode 3 :     sélection si DID = DNI (par le neurone destination),
mode 4 :     sélection si SID = SNI et DID = DNI (par les deux neurones).

- Si dans un mode donné la condition est satisfaite, le signal SEL émis par les moyens d'adressage ADDR est à l'état actif.
- Dans le cas inverse, ledit signal SEL est mis à l'état inactif.

Dans le cas de la sélection suivant le quatrième mode, il faut que les deux identificateurs SNI et DNI aient été tous les deux reconnus. Ceci est déterminé par une porte ET 57 dont la sortie entre dans une unité de contrôle 59. Pour les autres modes de sélection, les sorties des comparateurs 52 et 54 entrent respectivement dans deux portes OU 55 et 56 qui reçoivent également respectivement les filtres source SF et destination DF. Les sorties des portes OU 55, 56 entrent ensuite dans la porte ET 57.

L'unité de contrôle 59 reçoit plusieurs champs de données et plusieurs signaux d'activation.

Elle reçoit :

- le signal entrant BUSY I en provenance de la cellule synaptique précédente,
- le signal d'occupation FR/OC en provenance des moyens d'allocation ALLOC de la cellule synaptique courante,
- le champ de type d'opérations TYPE,
- le bit d'allocation "alloc" mis en oeuvre au cours des étapes d'allocation de ladite cellule synaptique,
- le signal de coïncidence d'adresse (sortie de la porte ET 57).

L'unité de contrôle 59 effectue les contrôles suivants :

. Pour l'instruction d'allocation, le signal SEL est activé lorsque :

- le type d'instruction est "gestion de synapse" (Tableau I),
- le bit "alloc" du champ DATA est actif,
- BUSY I = 1 (activé) et FR/OC = 0 (libre) (ceci correspond à la première cellule synaptique libre).

. Pour les autres instructions, le signal SEL est activé lorsque :

- la sortie de la porte ET 57 est à l'état actif,

- le signal FR/OC est à l'état occupé (FR/OC = 1).

Les moyens de traitement PROCES 35 sont représentés sur la figure 7. Ils effectuent différentes opérations sur le champ de données DATA qui renferme lui-même, selon le type d'instruction, différents champs se rapportant aux états des neurones source/destination, au coefficient synaptique, à des commandes de sélecteurs ou de chargement.

Un état neuronal SNV du neurone source et un état neuronal DNV du neurone destination sont stockés respectivement dans des registres 61, 63. Ils peuvent aussi être chargés avec des erreurs à rétropopager au cours d'étapes d'apprentissage par rétropropagation d'erreurs. Le coefficient synaptique CV est stocké dans un registre 65. Un registre 67 sert à stocker un résultat M, par exemple un cumul au cours d'opérations cycliques effectuées dans une suite d'opérations de même nature.

Des sélecteurs 62, 64 permettent de sélectionner, bit par bit, les valeurs des états neuronaux stockés respectivement dans les registres 61 et 63. Deux sélecteurs 66, 68 sont disposés sur chacune des entrées d'un additionneur-soustracteur 69.

Le sélecteur 66 sélectionne parmi les données suivantes:

- état neuronal DNV du neurone destination,
- le champ de données entrantes DI contenu dans le champ de données DATA,
- le coefficient synaptique CV,
- une valeur zéro.

Le sélecteur 68 reçoit soit la sortie du registre 67 soit une valeur zéro.

L'additionneur-soustracteur 69 fournit un résultat qui peut être réintroduit (avec possibilité de décalage d'un bit vers la droite par un décaleur 92) à l'entrée du registre 67 pour opérer des cumuls avec des valeurs précédentes stockées dans M. A la fin d'un cycle d'opérations, l'additionneur-soustracteur 69 fournit un champ de données sortantes DO à la cellule synaptique suivante. On observe que le chemin de données DATA est interrompu par chaque cellule synaptique qui peut soit apporter sa contribution propre soit opérer en fonctionnement transparent.

Un bloc de contrôle 60 fournit différents signaux de contrôle à la cellule synaptique :

. des signaux de sélection S (champ à plusieurs bits) aux sélecteurs 62, 64, 66, 68, 92,
. le choix "addition" ou "soustraction" pour l'unité arithmétique (connexion 91),
. des signaux de chargement CH (champ à plusieurs bits) aux registres 51, 53, (figure 6) 61, 63, 65, 67 (figure 7),
. des signaux SET, RESET au registre 312 (figure 5).

Le bloc de contrôle 60 reçoit :

. le signal d'horloge CL dont sont dérivés les signaux de chargement et les signaux SET et RESET,
. le signal de sélection SEL indiquant que la cellule synaptique est concernée ou non par l'opération,
. le bus de type d'opérations TYPE,
. certains bits (FLAG) contenus dans le champ DATA pour permettre de positionner les sélecteurs, paramétrer les additionneurs-soustracteurs.

Pour opérer soit l'allocation d'une cellule synaptique (SET = 1) soit sa libération (RESET = 1), le bloc de contrôle 60 contient le circuit d'allocation représenté sur la figure 4. Un décodeur 40 détecte si la cellule synaptique est concernée par une instruction de type "gestion de synapse".

Lorsque la cellule synaptique est concernée, la sortie du décodeur 40 est activée. Cette sortie entre avec le bit FREE et l'horloge CL dans une porte ET 42. Lorsque ces trois signaux sont activés simultanément, le signal RESET (porte ET 42) est activé.

La sortie du décodeur 40 entre également avec le bit "alloc" et l'horloge CL dans une porte ET 41. Lorsque ces trois signaux sont activés simultanément, le signal SET (porte ET 41) est activé.

Différentes opérations peuvent être effectuées par le processeur neuronal. Elles sont mises en oeuvre par un jeu d'instructions :

- salloc... allocation de synapses.
  Cette commande cherche la première synapse libre, y charge les identificateurs des neurones source et destination et déclare la synapse occupée.
- sfree... libération de synapses.
  Cette commande libère la/les synapses identifiées.

Cette dernière instruction peut concerner plusieurs synapses simultanément.

D'autres instructions opèrent à l'intérieur d'une même cellule synaptique :

- read : lecture d'un coefficient synaptique.

  Cette commande provoque, au sein de la cellule synaptique identifiée, la lecture du coefficient synaptique qui apparaîtra à la sortie du processeur neuronal à la fin du temps de latence. Le sélecteur 66 reçoit CV et le sélecteur 68 reçoit O (figure 7). L'additionneur-soustracteur 69 délivre alors CV sur le bus de données DO afin de pouvoir extraire les coefficients synaptiques stockés. Ceci est par exemple utile après une phase d'apprentissage.

- write ... écriture des valeurs d'états de neurones et/ou des coefficients synaptiques.

  Cette instruction charge la valeur SNV, DNV, CV ou M dans les registres 61, 63, 65, 67 lorsque la commande appropriée est activée (champ CH).

- accu ... accumulation des contributions des synapses.

  Cette commande permet d'effectuer la sommation des contributions des synapses. Les cellules synaptiques concernées ajoutent le contenu de leur accumulateur M à la somme partielle entrante et envoient le résultat à la cellule synaptique suivante. Suivant les valeurs des filtres source SF et destination DF, on obtient les résultats suivants :

  1. $SF = 0$, $DF = 0$ : non utilisé.
  2. $SF = 1$, $DF = 0$ : toutes les synapses en aval d'un neurone sont concernées. Cette combinaison est utilisée pour rétropropager les erreurs en apprentissage.
  3. $SF = 0$, $DF = 1$ : toutes les synapses en amont d'un neurone sont concernées. Cette combinaison est utilisée dans la phase d'évaluation pour calculer le potentiel d'un neurone.
  4. $SF = 1$, $DF = 1$ : lecture du contenu de l'accummulateur d'une cellule synaptique particulière.

- alu ... opération arithmétique interne.
- multi ... multiplications sur un bit.

  Cette commande permet d'effectuer l'accumulation d'un produit partiel d'une multiplication d'un multiplicande par un bit d'un multiplicateur. C'est une primitive de la multiplication en entiers signés, qui sera réalisée par une succession d'autant d'instructions multi que le multiplicateur a de bits. La première instruction charge M par le premier produit partiel décalé vers la droite. Les suivantes ajoutent au contenu de M le nouveau produit partiel, et rechargent le résultat décalé vers la droite dans M. La dernière instruction réalise une soustraction à la place de l'addition, et recharge le résultat sans décalage.

  Les sélecteurs 62 et 64 extraient des registres SNV et DNV les bits (connexions 90a et 90b) correspondant au rang spécifié dans l'instruction. Suivant les choix du multiplicateur et du multiplicande spécifiés dans l'instruction, et en fonction des bits présents sur les connexions 90a et 90b, on positionne le sélecteur 66 soit sur DNV, soit sur CV soit sur 0. L'unité arithmétique ajoute ou soustrait, suivant la spécification de l'instruction, la sortie du sélecteur 66 à celle du sélecteur 68. Enfin, le résultat est rechargé dans le registre M, avec ou sans décalage vers la droite de 1 bit, également sous contrôle de l'instruction.

  Le processeur neuronal peut ainsi être programmé pour allouer des neurones source et destination à chaque cellule synaptique. Leurs nombres peuvent être modifiés dynamiquement. On peut programmer des types d'opérations concernant des phases de résolution au cours desquelles les registres d'états de neurones sont chargés par des états de neurones ou concernant des phases d'apprentissage au cours desquelles les registres d'états de neurones sont chargés par des erreurs à retropropager.

  Comme cela est indiqué sur la figure 3, le processeur neuronal peut être formé par une chaîne linéaire de cellules synaptiques. Une cellule synaptique entrante reçoit la totalité des informations : (contrôle + adresses + données), apporte éventuellement sa propre contribution et transmet par les chemins chaînés des informations (modifiées ou non) à la cellule synaptique qui suit. Lorsqu'une cellule synaptique n'est pas concernée, elle passe la main à la cellule synaptique suivante. Ainsi à un instant donné, chaque cellule synaptique effectue un traitement qui peut être identique ou différent du traitement des autres cellules synaptiques.

  Après un temps de latence, il apparaît, à la sortie de la dernière cellule synaptique de la chaîne, un flux de résultats. Celui-ci doit être lu au rythme approprié pour être exploité.

  Si l'instruction implique des modifications de registres, un signal d'horloge CL est envoyé à la fin du temps de latence, ce qui a pour effet de charger simultanément tous les registres concernés.

Mode de réalisation complémentaire.

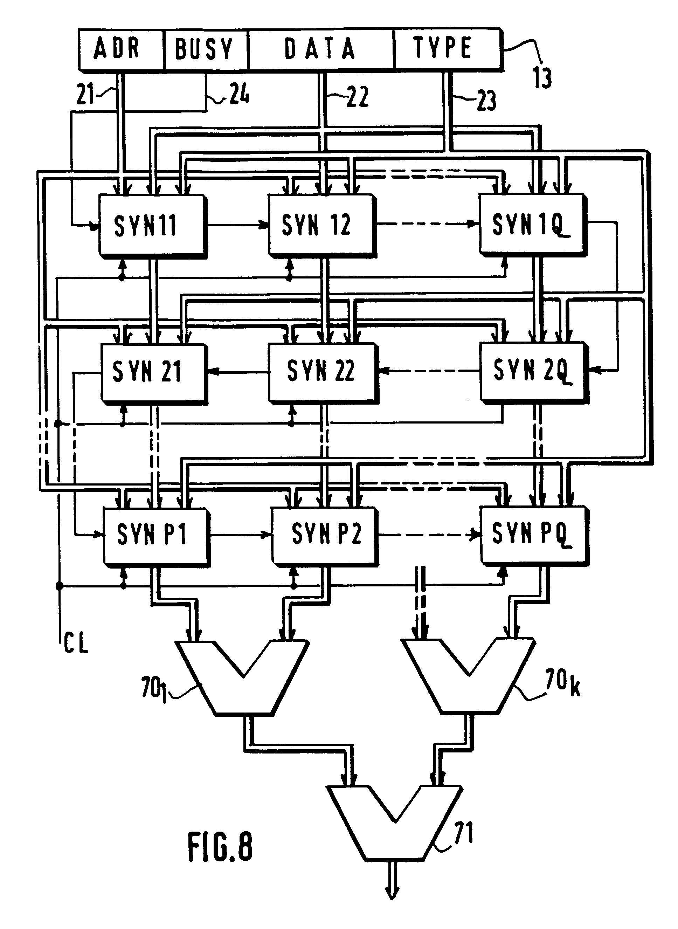

Pour réduire le temps de latence, la pluralité de cellules synaptiques peut être subdivisée en plusieurs groupes ordonnés de cellules synaptiques (figure 8). Par exemple :

un premier groupe SYN 11, SYN 21, ... SYN P1,
un deuxième groupe SYN 12, SYN 22, ... SYN P2,
un dernier groupe SYN 1Q, SYN 2Q, ... SYN PQ.

Chaque groupe est ordonné de la même manière comme cela est présenté sur la figure 3 :

. les communications en parallèle, par le bus ADR et par le bus TYPE sont effectuées en parallèle sur tous les groupes,
. le chemin chaîné BUSY passe dans toutes les cellules synaptiques, d'abord dans toutes les premières cellules synaptiques de chaque groupe puis dans toutes les secondes cellules synaptiques de chaque groupe et ainsi de suite jusqu'aux dernières cellules synaptiques,
. le chemin chaîné DATA est subdivisé sur tous les groupes. La communication s'effectue donc en parallèle sur tous les groupes de cellules synaptiques. Elle se poursuit en chemin chaîné à l'intérieur d'un groupe. Dans le cas d'une instruction d'accumulation, le champ DATA n'est envoyé que dans un groupe, les autres groupes recevant 0.

Les résultats délivrés par les dernières cellules synaptiques SYN P1, SYN P2, ... SYN PQ de chaque groupe sont cumulés dans un arbre d'additionneurs formé de plusieurs additionneurs en cascade $70_1$, $70_k$, 71 dans la cas d'une instruction d'accumulation. Pour les autres instructions, des précautions sont prises pour neutraliser ces additionneurs pour ne pas altérer le contenu des chemins DATA.

Autre mode complémentaire de réalisation.

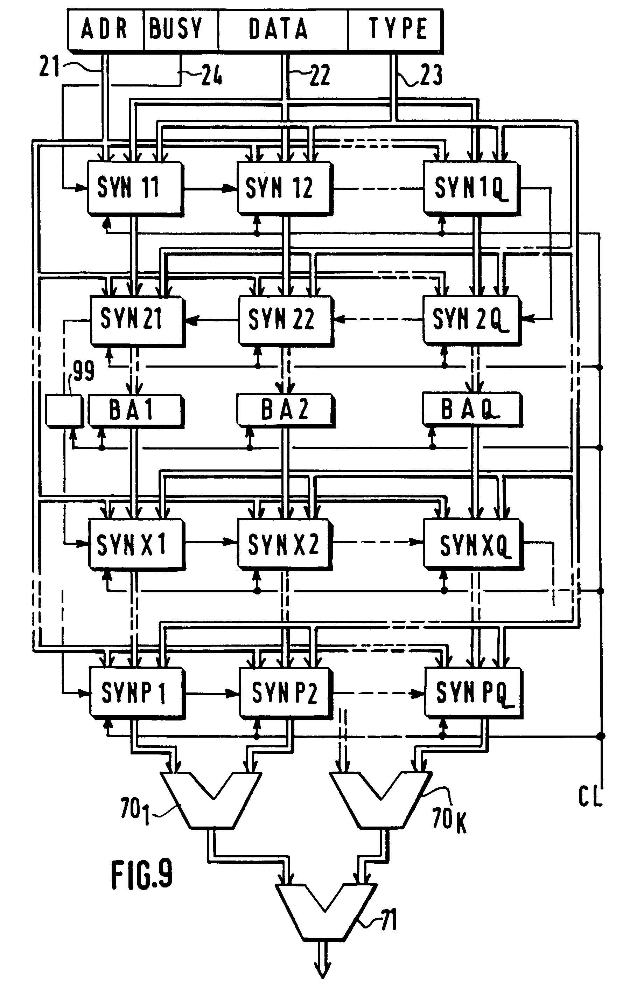

Il est possible de réduire le temps de cycle en plaçant dans chaque groupe des barrières de pipeline comme cela est représenté sur la figure 9. Ces barrières de pipeline formées de registres BA1, BA2 ... BAQ sont disposées après un certain nombre de cellules synaptiques, formant une section. Ainsi dans un même groupe, une section pourra être concernée par des opérations d'accumulation au cours d'un cycle de pipeline pendant qu'une autre section sera concernée par des opérations d'écriture. Pour des questions de synchronisation, il est préférable qu'entre deux barrières de pipeline, chaque section renferme un même nombre de cellules synaptiques. Le chargement des registres BA1, BA2, ... BAQ est déclenché par le signal d'horloge CL.

L'utilisation du pipeline nécessite une adaptation du dispositif pour la réalisation de la fonction allocation. En effet, si l'on ne modifiait pas le circuit, une seule instruction d'allocation émise dans le circuit pourrait provoquer autant d'allocations que de tranches (ensemble des sections de même rang de chaque groupe), ce qui est contraire au résultat escompté. Pour parer à ce problème, la première allocation, effectuée dans la première tranche où les conditions sont satisfaites, bloque les allocations éventuelles effectuées dans les tranches suivantes. Pour cela, la barrière de pipeline contient également un registre 99 qui interrompt, en synchronisme avec les autres registres, la chaîne du signal BUSY. Après la barrière de pipeline, la chaîne BUSY se poursuit avec le premier rang de cellules synaptiques de la section suivante de chaque groupe (SYN X1, SYN X2... SYN XQ).

La délivrance des informations sur le bus 9 arrivant sur les moyens d'entrée 13 et la délivrance de l'horloge CL (figure 3) peuvent être réalisées par un calculateur hôte (non représenté) qui peut également prendre en charge des opérations de synchronisation en identifiant l'achèvement d'instructions. Une instruction nouvelle est alors lancée par le calculateur hôte lorsqu'une instruction fournie en entrée est détectée à la sortie du processeur neuronal. En mode pipeline, lorsqu'il n'y a pas de dépendance entre deux instructions successives, le calculateur hôte envoie l'instruction suivante dans le cycle de pipeline suivant. En cas de dépendance, le calculateur hôte attend la fin de l'instruction à la sortie du processeur neuronal. Les instructions peuvent concerner aussi bien des tâches d'exécution que des tâches d'apprentissage.

**Revendications**

1.  Processeur neuronal (10) comprenant :

    -   des moyens d'entrée (13) de signaux numériques,
    -   une pluralité de moyens de stockage (65) de coefficients synaptiques,
    -   une pluralité de moyens de stockage (61, 63) d'états de neurones,
    -   une pluralité de moyens de calcul (69) de potentiels neuronaux, caractérisé en ce que lesdites pluralités de moyens sont réparties unitairement dans une pluralité de cellules synaptiques (SYN 1 - SYN P) (SYN 11 - SYN PQ), une cellule synaptique étant allouée à une seule synapse, les cellules synaptiques :
- recevant en parallèle :

  . un bus d'adresses ADR (21),
  . un bus de type d'opérations TYPE (23),

- et communiquant en chaîne de l'une à l'autre par :

  . au moins un chemin chaîné DATA (22) pour propager des données,
  . et un chemin chaîné BUSY ($24_a$, $24_b$) pour propager un signal d'occupation,

chaque cellule synaptique comprenant :

- des moyens d'allocation ALLOC (31) pour attribuer, à ladite cellule synaptique, un état libre/occupé propagé par le chemin chaîné BUSY ($24_a$, $24_b$),
- des moyens d'adressage ADDR (33) :

  . pour stocker une adresse de ladite cellule synaptique, adresse formée d'un identificateur (SNI) de neurone source et d'un identificateur (DNI) de neurone destination,
  . et pour comparer ladite adresse et une adresse courante (SID, DID) fournie par le bus d'adresses ADR (21) pour déterminer si ladite cellule synaptique doit devenir opérante,

- des moyens de traitement PROCES (35) pour effectuer des opérations définies par le bus TYPE (23) et effectuées sur les données du chemin chaîné DATA (22).

2. Processeur neuronal selon la revendication 1 caractérisé en ce que le bus d'adresses ADR comprend un signal de filtrage SF et un signal de filtrage DF pouvant être activés indépendamment pour adresser respectivement soit toutes les cellules synaptiques connectées à un même neurone destination, soit toutes les cellules synaptiques connectées à un même neurone source et pouvant être activées simultanément pour adresser toutes les cellules synaptiques.

3. Processeur selon les revendications 1 ou 2 caractérisé en ce que la pluralité de cellules synaptiques comprend plusieurs groupes ordonnés (SYN 11 - SYN P1) (SYN 12 - SYN P2) (SYN 1Q - SYN PQ) de cellules synaptiques, un groupe ordonné étant muni d'un propre chemin chaîné DATA.

4. Processeur selon la revendication 3 caractérisé en ce que chaque cellule synaptique ayant dans son groupe ordonné un numéro d'ordre, le chemin chaîné BUSY passe, en progression croissante ou décroissante, dans des cellules synaptiques ayant, dans chaque groupe ordonné, un même numéro d'ordre, puis dans des cellules synaptiques, ayant dans chaque groupe ordonné, un même numéro d'ordre suivant.

5. Processeur selon les revendications 3 ou 4 caractérisé en ce que les groupes ordonnés sont subdivisés à l'identique en sections (SYN XQ - SYN PQ) qui sont séparées les unes des autres par des barrières de pipeline (BA1 - BAQ), les sections, adjacentes d'un même côté à une barrière de pipeline, ayant pour tous les groupes ordonnés un nombre identique de cellules synaptiques.


**Patentansprüche**

1. Neuronaler Prozessor (10) mit:

- Eingangsmitteln (13) für digitale Signale,
- einer Vielzahl von Mitteln zur Speicherung (65) von synaptischen Koeffizienten,
- einer Vielzahl von Mitteln zur Speicherung (61, 63) von Neuronenzuständen
- einer Vielzahl von Mitteln zur Berechnung (69) von neuronalen Potentialen, <u>dadurch gekennzeichnet,</u> daß die genannten Vielzahlen von Mitteln einheitlich in eine Vielzahl von synaptischen Zellen (SYN 1 - SYN P) (SYN 11 - SYN PQ) unterteilt sind, wobei eine synaptische Zelle einer einzelnen Synapse zugeordnet wird und die synaptischen Zellen
- parallel:

- einen Adreßbus ADR (21),
- einen Operationstypbus TYPE (23)

empfangen
- und in einer Kette von der einen zur anderen über:

- wenigstens einen verketteten Weg DATA (22) zur Übermittlung von Daten
- und einen verketteten Weg BUSY (24$_a$, 24$_b$) zur Übermittlung eines Besetzt-Signals

kommunizieren,

wobei jede synaptische Zelle folgendes umfaßt:

- Zuordnungsmittel ALLOC (31), um der genannten synaptischen Zelle einen über den verketteten Weg BUSY (24$_a$, 24$_b$) übermittelten Frei-/Besetzt-Zustand zuzuweisen,
- Adressierungsmittel ADDR (33):

- um eine Adresse der genannten synaptischen Zelle zu speichern, wobei die Adresse aus einem Ursprungsneuronenidentifikator (SNI) und einem Zielneuronidentifikator (DNI) gebildet wird,
- und um die genannte Adresse und eine durch den Adreßbus ADR (21) gelieferte laufende Adresse (SID, DID) zu vergleichen, um zu bestimmen, ob die genannte synaptische Zelle aktiv werden soll,

- Verarbeitungsmittel PROCES (35), um Operationen auszuführen, die durch den Bus TYPE (23) definiert und mit den Daten des verketteten Wegs DATA (22) ausgeführt werden.

2. Neuronaler Prozessor nach Anspruch 1, dadurch gekennzeichnet, daß der Adreßbus ADR ein Filtersignal SF und ein Filtersignal DF umfaßt, die unabhängig aktiviert werden können, um entweder jeweils alle synaptischen Zellen zu adressieren, die mit dem gleichen Zielneuron verbunden sind, oder alle synaptischen Zellen, die mit dem gleichen Ursprungsneuron verbunden sind, und gleichzeitig aktiviert werden können, um alle synaptischen Zellen zu adressieren.

3. Prozessor nach Anspruch 1 oder 2, dadurch gekennzeichnet, daß die Vielzahl synaptischer Zellen mehrere geordnete Gruppen (SYN 11 - SYN P1) (SYN 12 - SYN P2) (SYN 1Q - SYN PQ) von synaptischen Zellen umfaßt, wobei eine geordnete Gruppe mit einem eigenen verketteten Weg DATA ausgestattet ist.

4. Prozessor nach Anspruch 3, dadurch gekennzeichnet, daß jede synaptische Zelle in ihrer Gruppe eine Folgenummer hat, jeder verkettete Weg BUSY in auf- oder absteigender Progression in synaptische Zellen mit gleicher Folgenummer in jeder Gruppe und dann in synaptische Zellen mit einer folgenden Folgenummer in jeder Gruppe führt.

5. Prozessor nach Anspruch 3 oder 4, dadurch gekennzeichnet, daß die geordneten Gruppen identisch in Abschnitte (SYN XQ - SYN PQ) unterteilt werden, die voneinander durch Pipeline-Barrieren (BA1 - BAQ) getrennt sind, wobei die Abschnitte, die auf der gleichen Seite an eine Pipeline-Barriere angrenzen, bei allen geordneten Gruppen dieselbe Anzahl synaptischer Zellen haben.

## Claims

1. A neural processor, comprising:

- means (13) for the input of data,
- a plurality of means (65) for the storage of synaptic coefficients,
- a plurality of means (61, 63) for the storage of neuron states,
- a plurality of means (69) for the calculation of neural potentials, characterized in that said pluralities of means are unitarily distributed in a plurality of synaptic cells (SYN 4 - SYN P) (SYN 11 - SYN PQ), a synaptic cell being allocated to a sole, the synapsis, the synaptic cells:
- receiving in parallel:

- an address bus ADR (21)
- a type of operation bus TYPE (23),

- and communicating with one another in a chain via:

- at least one concatenated path DATA (22) for propagating data,
- and a concatenated path BUSY ($24_a$, $24_b$) for propagating a busy signal, each synaptic cell comprising:

- allocation means ALLOC (31) for attributing to said synaptic cell a state free/busy which is propagated via the concatenated path BUSY ($24_a$, $24_b$),
- addressing means ADDR (33):

- for storing an address of said synaptic cell, which address is formed by a source neuron identifier (SNI) and a destination neuron identifier (DNI), and
- for comparing said with a current address (SID, DID) supplied by the address bus ADR (21) in order to determine whether said synaptic cell is to become operative,
- processing means PROCESS (35) for performing operations defined by the type of operation bus TYPE (23) and performed on the data of the concatenated path DATA (22).

2. A neural processor as claimed in Claim 1, characterized in that the address bus ADR comprises a filter signal SF and a filter signal DF that can be independently activated in order to address either all synaptic cells connected to the same destination neuron or all synaptic cells connected to the same source neuron, and that can be simultaneously activated in order to address all synaptic cells.

3. A processor as claimed in Claim 1 or 2, characterized in that the plurality of synaptic cells comprises several ordened groups (SYN 11- SYN P1) (SYN 12 - SYN P2) (SYN 1Q - SYN PQ) of synaptic cells, an ordenend group being provided with a respective concatenated path DATA.

4. A processor as claimed in Claim 3, characterized in that, each synaptic cell having a rank number within its group, the concatenated path BUSY passes, in an ascending or descending sense, through synaptic cells of the same rank number in each ordened group, and subsequently through synaptic cells having a number of next rank in each group.

5. A processor as claimed in Claim 3 or 4, characterized in that the ordened groups identically subdivided into section (SYN XQ - SYN PQ) which are separated from one another by pipeline barriers (BA1 - BAQ), the sections adjacent a same side of a pipeline barrier having an identical number of synaptic cells for all ordened groups.

FIG.1

FIG.2

EP 0 558 125 B1

| ADR | BUSY | DATA | TYPE |

SYN 1

SYN 2

SYN P

FIG.3

FIG.4

15

BUSY I

24a

31

312

REG

SET

314

RESET

24b

BUSY 0    FR/OC

## FIG.5

ADR

SID  SF          DID  DF

TYPE  FR/OC  alloc (DATA)
                    BUSY I

51              53

SNI             DNI

CONTROL              SEL

CH

56          57

59

COMP            COMP

52              54

55

SID  SF          DID  DF

## FIG.6

FIG.7

FIG.8

FIG.9